# EUROPEAN PATENT APPLICATION

(11) **EP 4 718 088 A1**
(43) Date of publication of application: **01.04.2026**
(21) Application number: 25197255.0
(22) Date of filing: 21.08.2025
(51) Int. Cl.: G01R 31/28

(54) **INTERCONNECT BREAKDOWN TEST STRUCTURES AND METHODS**

(30) Priority: 26.09.2024 US 202418898345
(71) Applicant: INTEL Corporation, Santa Clara, CA 95054 (US)
(72) Inventor: LIN, Che-Yun, Beaverton, 97006 (US)
(74) Representative: HGF

(57) **Abstract**

Improved breakdown test structures are provided. In some embodiments, multiple test structures may be combined into a single (e.g., two-terminal) test structure for monitoring interconnect voltage breakdown (VBD) of representative interconnect structures within scribe line regions.

## Description

### TECHNICAL FIELD

Embodiments relate to the field of semiconductor manufacturing; and more specifically, to the field of interconnect structure breakdown voltage testing.

### BRIEF DESCRIPTION OF THE DRAWINGS

The disclosure may best be understood by referring to the following description and accompanying drawings that are used to illustrate embodiments of the invention. In the drawings:
Figs. 1A through 1C are schematic diagrams showing different views of a semiconductor wafer.
Fig. 2 is a top view of a wafer with interconnect breakdown test structures in accordance with some embodiments.
Figs. 3A-3D show exemplary interconnect breakdown test structures in accordance with some embodiments.
Figs. 4A and 4B show a portion of die and scribe line stacks with interconnect breakdown test structures in accordance with some embodiments.
Fig. 5A is a schematic diagram showing a portion of a wafer test apparatus in accordance with some embodiments.
Fig. 5B is a schematic diagram showing an IBD test circuit 525 in accordance with some embodiments.
Fig. 5C is a schematic circuit diagram showing individual breakdown test structures in accordance with some embodiments.
Fig. 5D is a schematic circuit diagram showing an aggregate test structure in accordance with some embodiments.
Fig. 6 is a flow diagram showing a routine for performing voltage breakdown tests on interconnect structures in accordance with some embodiments.

### DETAILED DESCRIPTION

In some embodiments, interconnect short-circuit test structures and test methods are provided. Representative interconnect structures that are vulnerable to voltage breakdown are identified and then formed in scribe line regions and tested to determine if they are sufficiently resistant to short circuiting. In some embodiments, multiple different test structure types may be combined into a relatively compact aggregate test structure using a reduced amount of scribe line surface area. Aggregate structure(s) can be formed within a scribe line region from an amalgamation of multiple different vulnerable interconnect structure types used in a die that is next to the scribe line region. The separate structures may be electrically coupled together in parallel so that a single test ramp can be simultaneously applied to the multiple structures. The aggregate structure can take relatively little scribe line real estate because the multiple structures (e.g., 5, 10, 15, or even 30+) can fit beneath two input pads used to connect them to a test apparatus. (Note that with scribe lines, test access pads typically take up much more footprint than the actual test circuit elements lying within and below them.) So area cost for such an aggregate structure can be relatively small. With the use of one or more aggregate test structures, testing time for wafers can be reduced because when the aggregate structure passes a voltage breakdown test (indicating its separate constituent structures are sound), the individual structures, in many cases, need not be separately tested.

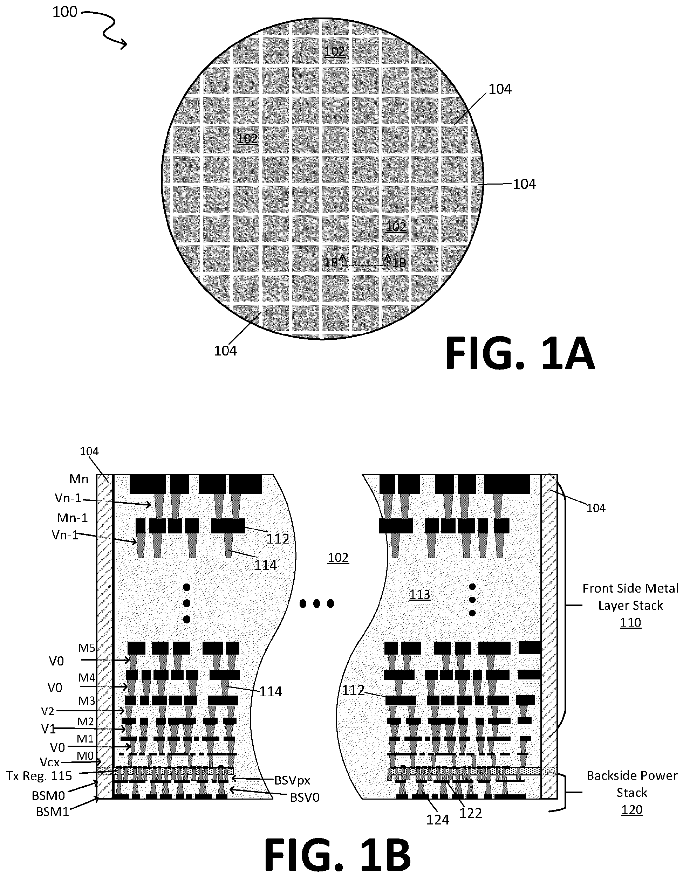

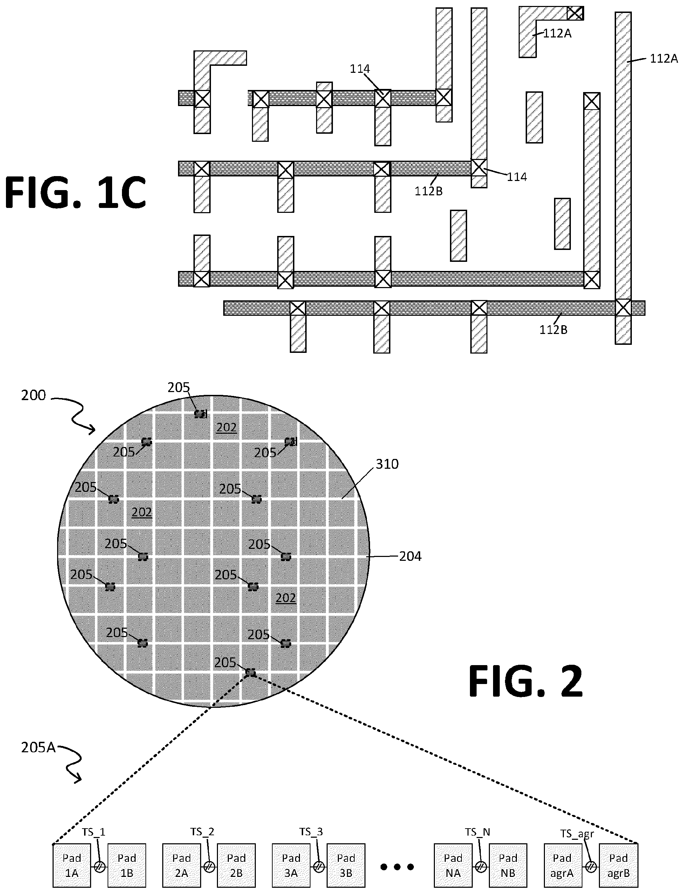

Figs. 1A through 1C are schematic diagrams showing different views of a semiconductor wafer 100. Fig. 1A is a top view of the wafer. Fig. 1B is a cross-sectional side view taken along line 1B-1B in Fig. 1A, and Fig. 1C is a top view showing exemplary metal traces and trace connections. Wafer 100 includes a plurality of IC (integrated circuit) dies 102 separated by scribe lines (also referred to as streets) 104. The scribe lines 104 are the areas where the dies 102 are sawed before the integrated circuits are assembled into IC packages. These scribe lines typically have widths between 40 and 150 microns and lengths for each scribe line portion for each die corresponding to die side dimensions, which depending on the die function may range from 1 to 30 mm.

Semiconductor manufacturers typically use test structures including test circuits within the scribe line (SL) regions for testing various fabricated die features. Since the available SL widths are very small, overall scribe line space for testing is at a premium given the amount of die features and circuitry that are to be tested.

As shown in Fig. 1B, a semiconductor die 102 typically has a transistor layer region 115 that includes the numerous transistors that are used by the IC die. In addition, there is a front side metal layer stack 110 formed atop the transistor layer 115 to facilitate interconnections between the different transistors as well as between the transistors and external IC package contacts (e.g., wires, pads, bumps).

The front side metal stack 110 includes alternating layers of metal traces 112 (also referred to as wires or lines) and vias 114. In the depicted embodiment, there are "n" (e.g., 15) metal layers, ranging from layer M0 to Mn, with interleaved via layers (Vcx through Vn-1) separated by one or more different dielectric materials 113. The metal layer traces and vias typically become smaller for layers that are closer to the lower layers where the Vcx vias ultimately connect with transistor layer terminal contacts (sometimes referred to as trench contacts, TCN).

Fig. 1C is a cross-sectional top view showing how metal layer traces 112 may be configured to connect from one layer to another layer through vias 114. In the depicted embodiment, the metal layer traces 112A are in a layer that is above the metal traces 112B. While the lines (aka traces) 112 are shown as linear strips or orthogonally dispositioned strips, it should be appreciated that the traces in each metal layer may be formed into any suitable shape, so long s the distinct discrete traces in a given metal layer are separated from each other in accordance with relevant minimum design separation rules.

In some embodiments, there may also be a backside power delivery stack 120 coupled to the transistor layer to provide power and ground supplies to the transistors through backside metal layers, BSMi, and backside power delivery vias, BSVi (where "i" is a number corresponding to a given backside layer level). In the depicted embodiment, there are two backside metal layers but in other embodiments, there may be more or less layers.

Unfortunately, as process technologies become increasingly complex, the number of interconnect features that need to be tested has increased. For example, with smaller transistor layer contacts, transistor contact vias (Vcx) and the other lower layer metal traces and vias, several different breakdown voltage integrity tests may need to be performed for several different feature breakdown scenarios in each layer, especially for the lower layers with their smaller feature dimensions and MDR (minimum design rule) separation requirements.

Accordingly, improved breakdown test structures are desired. In some embodiments, multiple test structures may be combined into a single (e.g., two-terminal) test structure for monitoring interconnect voltage breakdown (VBD) of representative interconnect structures within scribe line regions. In some embodiments, such an aggregate test structure may combine the worst-case VBD for a wide array of representative structures providing a reduction in test time without excessively exhausting scribe line real estate.

Fig. 2 is a top view of a wafer with interconnect breakdown test structures in accordance with some embodiments. Wafer 200 has IC dies 202 and scribe lines 204 that include interconnect breakdown (IBD) test structure regions 205 (not drawn to scale) as are illustrated. In the depicted embodiment, the IBD test structure regions (or simply test structure regions) 205 are distributed throughout the wafer but with less test structure regions than dies. It should be appreciated, however, that more or less test structure regions 205 could be employed. In some embodiments, there may be an IBD test structure region for each die, while in other embodiments, there may be even less test structure regions, depending, for example, on fabrication process consistency and uniformity.

In the depicted figure, a zoomed in view 205A of a test structure region is shown. The region includes N individual interconnect breakdown test structures (TS_1-TS_N) and an aggregate test structure (TS_Agr). Each of these test structures are disposed in a scribe line region beneath an associated pair of test contact pads. For example, test structure TS_1 is coupled to Pads 1A and 1B, test structure TS_2 is coupled to Pads 2A and 2B, and so on through test structure TS_agr being coupled to Pads agrA and agrB. (Note that scribe line regions in semiconductor wafers are typically not limited to the top metal layer. They are three-dimensional structures that can incorporate multiple layers including transistor, via, and metal layers, along with dielectric materials depending on specific design and manufacturing requirements, although they may or may not have layers corresponding to all of the layers in the functional dies. For example, they may include dummy materials for support and/or extended posts for connection between pads and contacts/traces.)

The use of one or more aggregate test structures can reduce consumed scribe line surface area given that the utilized test pads can occupy a large amount of scribe line real estate. For example, a typical scribe line pad may have lengths and widths in the range of 10 to 60 microns. So, even though the test structures themselves may be small (e.g., tens to hundreds of nm), the contact pads required to test them can make the overall test structure instances occupy a relatively large amount of scribe line space. Accordingly, in some embodiments, test structures such as TS_agr, which combine individual separate test structures (e.g., 30 or more separate IBD test structures) into one test structure can significantly free up space in the scribe line regions since they can facilitate breakdown testing of multiple separate structures using a single pair of contact pads. In addition, the combined test structure can represent a worst-case breakdown voltage (VBD) for all of the separate test structures resulting in a reduction of overall test time.

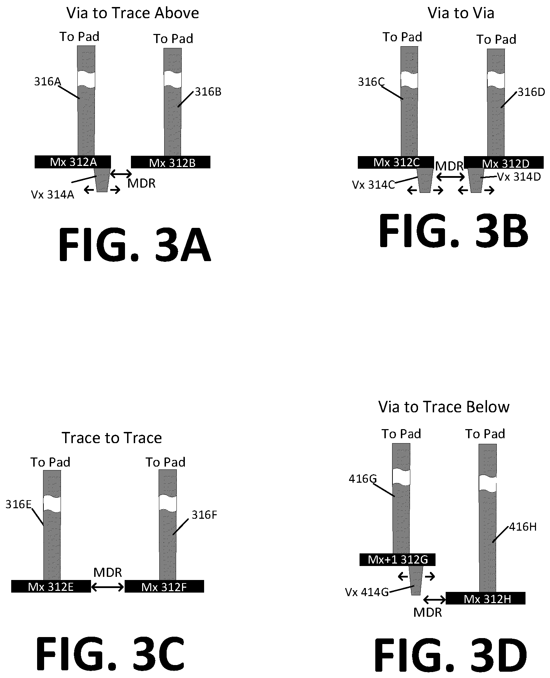

Figs. 3A-3D show exemplary interconnect breakdown test structures in accordance with some embodiments. They are used to test worst case interconnect breakdown scenarios, most of which will be in the lower metal and via layers, e.g., front and/or back side layers that are closer to the transistor layer. Interconnect defects (or inner-layer separation defects) can occur in any of the layers although they are most likely to occur in these lower (e.g., M0) layers. These defects involve insufficient separations or defective dielectric formation between separate traces (M:M defects), traces to vias (M:V defects), vias to vias (V:V defects) and via or traces to transistor contacts (V:TCN) to mention just a few.

Fig. 3A is a side schematic view showing an exemplary via to above-trace test structure in accordance with some embodiments. The IBD test structure includes traces 312A, 312B and via 314A, which is beneath the metal layer (Mx) containing the 312A, 312B traces. Also included are test access posts 316A, 316B for coupling the test structure to associated test pads on the surface of the scribe line. This test structure is used to test dielectric breakdown integrity for metal traces in the Mx layer to a via in the Vx-1 layer that are positioned as close as is allowed by the minimum design rule (MDR) for those layers. For example, it may detect when the fabrication process is mis-aligning or defectively forming Vx-1 layer vias and/or Mx layer traces.

Fig. 3B is a side schematic view showing an exemplary via to via IBD test structure in accordance with some embodiments. The test structure includes traces 312C, 312D and vias 314C, 314D. Also included are test access posts 316C, 316D for coupling the test structure to associated test pads on the surface of the scribe line. This test structure is used to test dielectric breakdown integrity for vias in the Vx-1 layer positioned close to each other as is allowed by the minimum design rule (MDR) for vias in this layer. This structure is used to detect, for example, when the fabrication process is mis-aligning or defectively forming Vx-1 layer vias.

Fig. 3C is a side schematic view showing an exemplary trace to trace IBD test structure in accordance with some embodiments. The test structure includes traces 312E, 312F in an Mx metal layer containing the 312E, 312F traces. Also included are test access posts 316E, 316F for coupling the test structure to associated test pads on the surface of the scribe line. This structure is used to test dielectric breakdown integrity for metal traces in the Mx layer that are positioned as close as is allowed by the minimum design rule (MDR) to each other. This structure is used to detect, for example, when the fabrication process is mis-aligning or defectively forming Mx layer traces.

Fig. 3D is a side schematic view showing an exemplary via to below-trace IBD test structure in accordance with some embodiments. The test structure includes traces 312G (Mx+1 layer) and 312H (Mx layer) and via 314G, which is above the metal layer (Mx) containing the 312H trace. Also included are test access posts 316G, 316H for coupling the test structure to associated test pads on the surface of the scribe line. This structure is used to test dielectric breakdown integrity for metal traces in the Mx layer to a via in the Vx layer that are positioned as close as is allowed by the minimum design rule (MDR) for those layers. This structure may be used to detect, for example, when the fabrication process is mis-aligning or defectively forming Vx layer vias and/or Mx layer traces.

In some embodiments, a row of test structures such as those indicated in Fig. 2 may be implemented with any suitable combination of these IBD test structure types in multiple different layers including in the front and/or backside layers. Such individual test structures including metal to metal, via to metal, via to metal-above, via to metal below, parallel facing vias, metal end to end, layer to layer, power via to contact metal, and power via to back side metal structures at minimum design rule separations may be employed. In some embodiments, a set of individual test structures, as well as an aggregate single test structure may include any suitable combination of the following test structure types: back side M0 to TCN (source/drain contacts) on P-diffusion, back side M0 to TCN contacts on N-diffusion, M0 line to line, V0 to M0, V1 to V1, V2 to M2, Via G (Via connecting to transistor gate) to M0, Via T (via connecting to source/drain contact), TCN to M0, M0 to metal end with V0, Via T to M0, Via G to M0, Via G to TCN, via T to TCN, via T to via G, TCN to DVB (power via), TCN to DVB (power via), TCN to DVB on P diffusion, bunker oxide (isolation between back side metal and transistor), breakdown on N diffusion, gate contact to DVB on N diffusion, gate contact to DVB on P diffusion, gate contact to DVB, bunker oxide (isolation between back side metal and transistor) breakdown on P diffusion, M1 line to M1 line, M2 line to M2 line, M3 line to M3 line, M4 line to M4 line, V5 to M5, V0 to M1, V1 to M2, M1 end to end, M2 end to end, M1 end to end, M0 to gate contact, and M0 to TCN.

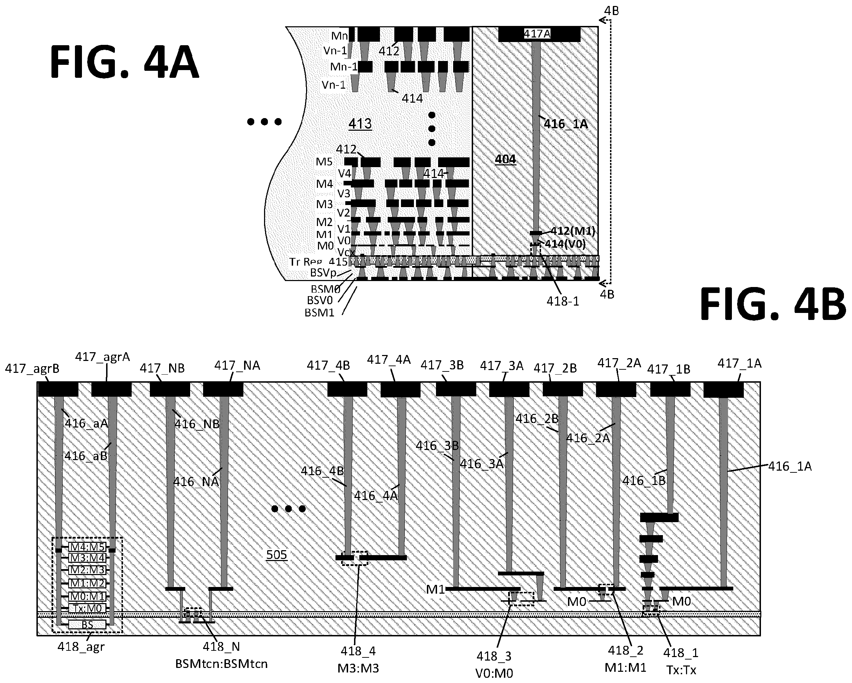

Figs. 4A and 4B show a portion of die and scribe line stacks with interconnect breakdown test structures in accordance with some embodiments. Fig. 4A is a cross-sectional side schematic view, while Fig. 4B is an end view of the diagram of Fig. 4A taken along line 4B-4B. As is indicated in these views, wafer scribe lines can include metal lines, vias and transistor features in some or all of the multiple layers that are used for the functional die. These scribe line structures are sometimes referred to as dummy structures since they are not used for the die but rather are used for such purposes as die testing, planarization, and structural integrity when the dies are cut away from a wafer. For example, the scribe line structure may include a patterned metal layer made of many small patterns just below surface layer a pads to help reduce the risk of chipping and other damage during the dicing process. Note however that while scribe lines generally include multiple layers, certain layers, such as isolation metal layers, may be excluded to prevent leakage or short-circuit problems. This exclusion is specific to the design and functional requirements of the semiconductor device.

The depicted wafer portion includes individual test structures 418_1 through 418_N, along with an aggregate test structure 418_agr, distributed as shown. Each test structure has a pair of test access posts 416 to couple the test structure to an associated pair of test pads 417. For example, test structure 418_1 is coupled to test pads 417_1A/417_1B through test access posts 416A/416B, as well possibly with other trace segments and vias, to sufficiently access the test structure.

(Note that the test access posts 416 may be formed from any suitable structures such as vias and metal layer lines (traces) and/or extended via structures that maybe used in the scribe line regions. Note also that while the depicted test pads are placed in the scribe lines providing convenient access to test probe needles for electrically testing the test structures, in other implementations, different configurations may be used. For example, they may be positioned in adjacent chip areas, e.g., using top metal layers. With multiple metal layers and vias connecting the test structures to these pads in the chip area, smaller scribe lines may be used while still providing access to the test structures. In other cases, there may still be smaller pads within the scribe lines themselves in addition to larger pads in the chip area. The specific layout and connection scheme will typically vary depending on particular design objectives and test requirements.)

The depicted test structures 418 provide a variety of voltage breakdown tests for different structural separation scenarios such as are listed above. For example, test structure 418_1 provides a transistor contact to transistor contact (Tx:Tx) breakdown separation test; structure 418_2 provides an M0 line to M0 line (M0:M0) breakdown separation test; test structure 418_3 provides a V0 via to M0 line breakdown separation test; test structure 418_4 provides an M3 line to M3 line breakdown separation test; and test structure 418_N provides a backside transistor contact to backside transistor contact (BStcn:BStcn) breakdown separation test. In addition, aggregate (or combination) test structure 418_agr provides a test structure that consolidates all or some of these N separate individual test structures for testing the worst case breakdown voltage in a single test voltage sweep process. In this example, the combined test structure 418_agr includes six layers (BS through M4:M5) of test structures with each layer including one or more separate breakdown separation test structures, all coupled to test pads 417_agrA/417_agrB through test access posts 416_aA/416_aB.

In some examples, it was determined that the individual test structures, when defective, had voltage breakdown levels ranging from 7 V to upwards of 30 V or higher. Since dielectric/conductor defect break down typically behaves as a weakest link fail mechanism, and the aggregate structure contains the individual structures including the weakest link structures, it allows for all of these weakest link structures to be tested in a single sweep using the aggregate structure. The weakest of these weakest link structures will break first when being stressed in parallel. As a result, the breakdown voltage of the aggregate structure can represent the lowest floor of the set of individual structures combined together. In turn, this allows for more time efficient testing. With an aggregate test structure, not only can a set of individual interconnect test structures be tested in a single process (e.g., voltage sweep), but also, the range of the sweep can be reduced as compared with the ranges required for some of the individual structures. For example, with an aggregate structure, a range of 0 to 10 V may be used as compared with a range of O to 40 V that may be required for some of the test structures, e.g., the breakdown test structures in the higher layers.

Using a voltage sweep on an aggregate structure can be effective in reducing overall test time because the aggregate structure breaks down at the lowest breakdown voltage of all of the fail mechanisms to be monitored. For example, with breakdown voltages for the various structures ranging from 7 V to 40 V, the aggregate structure would break down at a median level of 7 V. So for defective devices, the breakdown testing can often times stop at around 7 V. When compared to the 40 V breakdown for structures in the higher metal layers to be tested, use of aggregate structures can offer almost a 6x savings in test time.

In some embodiments, aggregate structures can offer 30:1 compression in test time. For a 7 V breakdown structure, the multiplier is 1x, but for a 14 V breakdown structure, there's a 2x multiplier, and for a 42 V structure, the multiplier is 6x. As an example, if we have a aggregate structure that combines three structures into one aggregate structure with the individual structure breakdown voltages being 7 V, 14 V, and 42 V, which roughly represents the VBD of a contact layer, middle of line interconnect, and an upper layer such as metal layer 8, respectively. At a voltage ramp rate of 1 V/sec, testing the aggregate structure would take 7 sec to complete. In contrast, if the individual structures were tested separately as discrete structures, it would take 7 sec + 14 sec + 42 sec = 63 sec to complete. So with this example, testing an aggregate structure offers 63/7 = 9x test time savings as compared with the three to one structure layout compression.

Interconnect breakdown test often take 1-3 days of test time to fully construct a model. On with 30+ structure SLs, there are often 10 or more critical fail modes that may need to get SL reliability tests. At a rate of 1-3 days per structure, testing on 10 structures can take 10 - 30 days. In an HVM environment, this long test time can be prohibitively expensive for the testing tools and testing hours required. This does not even account for the business impact for delayed decision making. The ability for an aggregate structure to complete these 10 structure tests from 10 - 30 days into just 1 - 3 days can provide a significant advantage in time and cost savings.

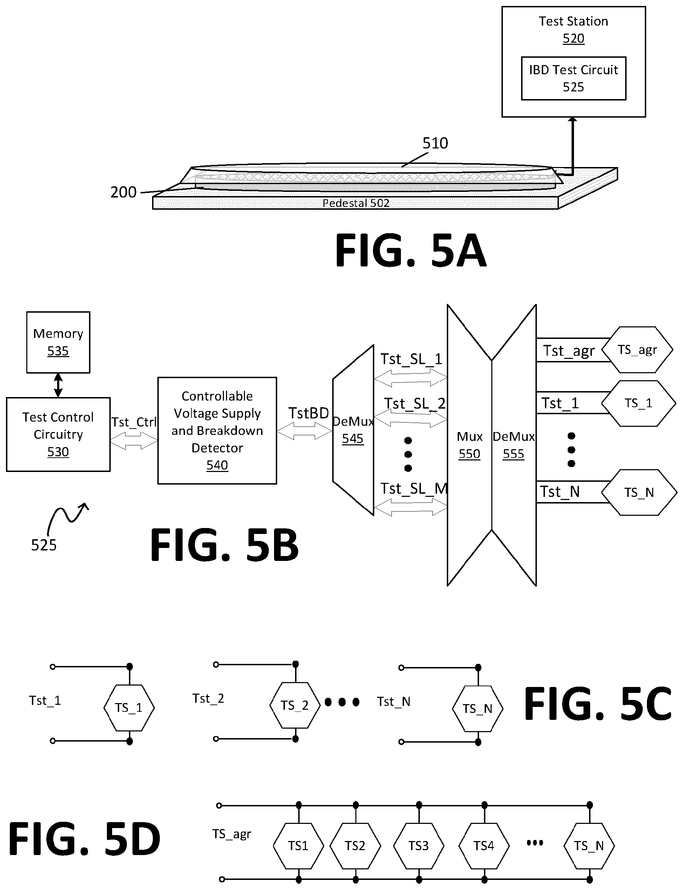

Fig. 5A is a schematic diagram showing a portion of a wafer test apparatus in accordance with some embodiments. The apparatus includes a pedestal 502 to support a semiconductor wafer 200 while a test probe assembly 510 is positioned over it to perform electrical tests through test pads such as scribe line pads 417. The test probe assembly 510 may include a plurality of needle probes that can be positioned to make contact with the utilized test pads on the wafer. The test apparatus also includes a test station 520 with interconnect breakdown (IBD) circuitry 525 for conducting voltage breakdown tests on breakdown test structures such as those described above.

Fig. 5B is a schematic diagram showing an IBD test circuit 525 in accordance with some embodiments. Fig. 5C is a schematic circuit diagram showing individual breakdown test structures, and Fig. 5D is a schematic circuit diagram showing an aggregate test structure. The depicted IBD test circuit includes test control circuitry 530 with associated memory 535, controllable voltage supply and breakdown detection circuitry 540, de-multiplexer (DeMux) 545, and Mux/DeMux 550/555, all coupled together as shown. The test control circuitry 530 may execute machine instructions from memory 535 for controlling the voltage supply/breakdown detector to perform breakdown tests on test structures as selected through DeMux 545 and Mux/DeMux 550/555. The test control circuit 530 controls DeMux 545 to select a scribe line test region (Tst_SL_1 through Tst_SL_M) for breakdown testing. Each of these SL regions may include a plurality of individual breakdown test structures and at least one aggregate test structure.

The test control circuitry 530 also controls Mux/DeMux 550/555 to select a specific test structure (TS_agr or one of TS_1-TS_N) to perform a breakdown test on the selected structure. The signal lines (TstBD, Tst_SL_1-Tst_SL_M, and Tst_agr and Tst_1-Tst_N) comprise signal line pairs for providing a controllable output voltage supply to a test structure.

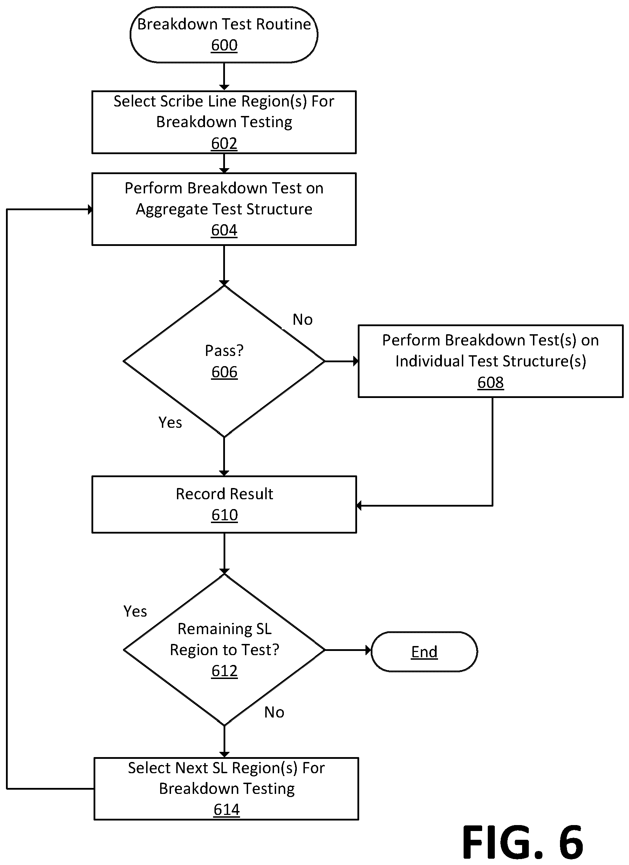

The control circuit 530 may be implemented with any suitable combination of one or more processors, controllers, and/or finite state machine circuits. It may correspond to dedicated control circuitry for an IBD test apparatus, or it may be part of a broader test station tool. As such, memory 535 has instructions that when executed by control circuitry 530 control operation of the IBD test apparatus 525 to perform IBD measurements as discussed further below with respect to the routine of flow diagram 600 in Fig. 6.

In some embodiments, depending on the configuration of the utilized test probe assembly 510, some or both of the DeMux and Mux/DeMux may be reduced or even omitted, e.g., to simultaneously test structures from multiple different SL regions with a sufficient number of probes to be in operable contact with the test pads. In some embodiments, the muxes and demuxes may be implemented with a solid state switch matrix circuit or with a combination of separate analog switch configurations.

Similarly, the controllable voltage supply and breakdown detector may be implemented with any suitable circuitry to generate a sequence of desired voltages onto a pair of test structure test pads, e.g., ranging from 0 to 40 V and to be able to detect when a structure under test breaks down, e.g., what voltage level causes it to effectively short circuit. In some embodiments, voltage steps of 100 or more mV may be applied. Likewise, the breakdown detector may be implemented with any suitable circuitry for recognizing when the structure has broken down, e.g., functionally shorting with relation to given design reliability parameters. For example, it may incorporate a current meter within the voltage supply to essentially monitor the effective resistance of a test structure being tested. It may measure the actual resistance or it may determine if/where the drawn current goes above a current threshold for the test structure.

Fig. 6 is a flow diagram showing a routine 600 for performing voltage breakdown tests on interconnect structures in accordance with some embodiments. Initially, at 602, a scribe line region in a wafer is selected for interconnect structure voltage breakdown testing. At 604, a breakdown test is performed on an aggregate interconnect test structure in the region. In some embodiments, this may be done by applying an incrementally increasing voltage, as described above, to determine if it has a short circuit or insufficiently low breakdown voltage level. The voltage may be gradually increased until a maximum test voltage has been applied without the structure breaking down or until it does in fact break down.

At 606, it determines if the breakdown test passed. If not, then at 608, it performs breakdown tests on individual test structures, e.g., those represented in the aggregate test structure, to identify the defective interconnect structure scenario(s). From here, it proceeds to 610 and records the results. On the other hand, if at 606, it was determined that the aggregate test passed, the routine would then have proceeded directly to 610 and record the result.

From here, the routine goes to 612 and determines if there is another SL interconnect test structure region to be tested. If not, then the routine ends. On the other hand, if there is another SL region to test, then it goes to 614 and selects the region(s) to test and loops back to 604 proceeding as already described.

It should be appreciated that in some embodiments, routine 600 may be performed on a wafer with scribe line pads on a top surface that couples with back side interconnect test structures, as well as with front side interconnect test structures. In other embodiments, separate SL regions may be located on scribe lines for each of the front and back sides, and the tests may be performed solely and/or separately for each side.

Illustrative examples of the technologies disclosed herein are provided below. An embodiment of the technologies may include any one or more, and any compatible combination of, the examples described below.

Example 1 is a method for a wafer with a first scribe line region having an aggregate interconnect breakdown (IBD) test structure with first and second test pads coupled to a plurality of separate IBD test structures. The method includes applying a test voltage to the first and second test pads. The method also includes incrementing the applied voltage until either a breakdown is detected or an upper test voltage limit is reached.

Example 2 includes the subject matter of example 1, and comprising individually testing additional instances of the separate IBD test structures if the breakdown is detected.

Example 3 includes the subject matter of any of examples 1-2, and comprising testing a different aggregate IBD test structure in a different scribe line region of the wafer if the upper test voltage limit is reached without detection of a breakdown.

Example 4 includes the subject matter of any of examples 1-3, and wherein the plurality of separate IBD test structures are disposed in the scribe line region below the first and second test pads.

Example 5 includes the subject matter of any of examples 1-4, and wherein the separate IBD test structures include test structures disposed in metal and via layers of the scribe line region that correspond to metal and via layers of a die in the wafer.

Example 6 includes the subject matter of any of examples 1-5, and wherein the separate IBD test structures include metal to metal and metal to via IBD test structures in an M0 metal layer.

Example 7 includes the subject matter of any of examples 1-6, and wherein the separate IBD test structures include metal to metal and metal to via IBD test structures in a backside power delivery layer.

Example 8 is a computer readable storage medium having instructions that when executed by a control circuitry perform a method in accordance with the subject matter of any of examples 1-7.

Example 9 is a wafer test apparatus that includes the control circuitry and computer readable storage medium as recited in example 8.

Example 10 is a wafer test apparatus that includes a pedestal, a test probe assembly and a test station. The pedestal is to support a wafer under test for a wafer that includes a scribe line region including: (i) a first plurality of separate interconnect breakdown (IBD) test structures each coupled to an associated separate pair of first plurality test pads, and (ii) a first aggregate IBD test structure having a pair of aggregate test pads coupled to a second plurality of IBD test structures corresponding to the first plurality of separate IBD test structures. The test probe assembly includes probe contacts to couple with the aggregate and first plurality test pad pairs. The test station is to be coupled with the test probe assembly to perform a voltage breakdown test on the aggregate IBD test structure.

Example 11 includes the subject matter of example 10, and wherein the test station is to perform voltage breakdown tests on the first plurality of IBD test structures if the voltage breakdown test on the aggregate IBD test structure detects a breakdown failure.

Example 12 includes the subject matter of any of examples 10-11, and wherein the test station is to perform voltage breakdown tests on a different aggregate IBD test structure in a different scribe line region of the wafer if the voltage breakdown test on the first aggregate IBD test does not detect a breakdown failure.

Example 13 includes the subject matter of any of examples 10-12, and wherein the test station includes and IBD test circuit including a controllable voltage supply to apply an incrementally increasing test voltage at the pair of aggregate test pads until either a breakdown is detected or an upper voltage limit is reached without a detected breakdown.

Example 14 includes the subject matter of any of examples 10-13, and wherein the IBD test circuit includes a breakdown detection circuit to determine if there is a breakdown of the first aggregate IBD test structure.

Example 15 includes the subject matter of any of examples 10-14, and wherein the breakdown detection circuit is part of the controllable voltage supply.

Example 16 includes the subject matter of any of examples 10-15, and wherein the second plurality of IBD test structures are disposed in the scribe line region below the pair of aggregate test pads.

Example 17 includes the subject matter of any of examples 10-16, and wherein the first plurality of separate IBD test structures include test structures disposed in metal and via layers of the scribe line region that correspond to metal and via layers of a die in the wafer.

Example 18 includes the subject matter of any of examples 10-17, and wherein the first plurality of separate IBD test structures include metal to metal and metal to via IBD test structures in an M0 metal layer.

Example 19 includes the subject matter of any of examples 10-18, and wherein the plurality of separate IBD test structures include metal to metal and metal to via IBD test structures in a backside power delivery layer.

Example 20 is a semiconductor wafer that includes a plurality of dies separated by scribe lines. The plurality of dies include a transistor layer and alternating metal and via layers coupled to the transistor layer through metal layer traces and vias. There is at least one scribe line region in the scribe lines. The scribe line region includes (i) a first plurality of separate interconnect breakdown (IBD) test structures each coupled to an associated separate pair of first plurality test pads, and (ii) a first aggregate IBD test structure having a pair of aggregate test pads coupled to a second plurality of IBD test structures corresponding to the first plurality of separate IBD test structures.

Example 21 includes the subject matter of example 20, and wherein the second plurality of IBD test structures are disposed in the scribe line region below the pair of aggregate test pads.

Example 22 includes the subject matter of any of examples 20-21, and wherein the first plurality of separate IBD test structures include test structures disposed in metal and via layers of the scribe line region that correspond to at least some of the metal and via layers of the plurality of dies.

Example 23 includes the subject matter of any of examples 20-22, and wherein the first plurality of separate IBD test structures include metal to metal and metal to via IBD test structures in an M0 metal layer.

Example 24 includes the subject matter of any of examples 20-23, and wherein the plurality of separate IBD test structures include metal to metal and metal to via IBD test structures in a backside power delivery layer.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types such as carbon nanotubes or spintronic devices.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent upon the platform within which the present disclosure is to be implemented.

As defined herein, the term "computer readable storage medium" means a storage medium that contains or stores program code for use by or in connection with an instruction execution system, apparatus, or device. As defined herein, a "computer readable storage medium" is not a transitory, propagating signal per se. A computer readable storage medium may be, but is not limited to, an electronic storage device, a magnetic storage device, an optical storage device, an electromagnetic storage device, a semiconductor storage device, or any suitable combination of the foregoing. Memory elements, as described herein, are examples of a computer readable storage medium.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, a system on a chip (SoC), an application processor, an integrated circuit incorporating a combination of one or more of the aforesaid items, etc.

A computer program product may include a computer readable storage medium (or media) having computer readable program instructions thereon for causing a processor to carry out aspects of various techniques described herein. Within this disclosure, the term "program code" is used interchangeably with the term "computer readable program instructions." Computer readable program instructions described herein may be downloaded to respective computing/processing devices from a computer readable storage medium or to an external computer or external storage device via a network, for example, the Internet, a LAN, a WAN and/or a wireless network. The network may include copper transmission cables, optical transmission fibers, wireless transmission, routers, firewalls, switches, gateway computers and/or edge devices including edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations described herein may be assembler instructions, instruction-set-architecture (ISA) instructions, machine instructions, machine dependent instructions, microcode, firmware instructions, or either source code or object code written in any combination of one or more programming languages, including an object oriented programming language and/or procedural programming languages. Computer readable program instructions may include state-setting data. In some cases, electronic circuitry including, for example, programmable logic circuitry, an FPGA, or a PLA may execute the computer readable program instructions by utilizing state information of the computer readable program instructions to personalize the electronic circuitry, in order to perform techniques described herein.

Certain techniques are described herein with reference to flowchart illustrations and/or block diagrams of methods, apparatus (systems), and computer program products. It will be understood that each block of a flowchart illustration and/or block diagram, and combinations of blocks in flowchart illustrations and/or block diagrams, may be implemented by computer readable program instructions, e.g., program code.

These computer readable program instructions may be provided to a processor of a general purpose computer, special purpose computer, or other programmable data processing apparatus to produce a machine, such that the instructions, which execute via the processor of the computer or other programmable data processing apparatus, create systems for implementing the functions/acts specified in flowchart(s) and/or block diagram block(s). These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the operations specified in the flowchart(s) and/or block diagram block(s).

In some alternative implementations, the operations noted in the blocks may occur out of the order noted in the figures. For example, two blocks shown in succession may be executed substantially concurrently, or the blocks may sometimes be executed in the reverse order, depending upon the functionality involved. In other examples, blocks may be performed generally in increasing numeric order while in still other examples, one or more blocks may be performed in varying order with the results being stored and utilized in subsequent or other blocks that do not immediately follow. It will also be noted that each block of the block diagrams and/or flowchart illustration, and combinations of blocks in the block diagrams and/or flowchart illustration, may be implemented by special purpose hardware-based systems that perform the specified functions or acts or carry out combinations of special purpose hardware and computer instructions.

While the invention has been described in terms of several embodiments, those skilled in the art will recognize that the invention is not limited to the embodiments described, can be practiced with modification and alteration within the scope of the appended claims. The description is thus to be regarded as illustrative instead of limiting.

## Claims

1. A method, comprising:
for a wafer with a first scribe line region including an aggregate interconnect breakdown, IBD, test structure with first and second test pads coupled to a plurality of separate IBD test structures, applying a test voltage to the first and second test pads; and
incrementing the applied voltage until either a breakdown is detected or an upper test voltage limit is reached.

2. The method of claim 1, comprising individually testing additional instances of the separate IBD test structures if the breakdown is detected.

3. The method of any of claims 1-2, comprising testing a different aggregate IBD test structure in a different scribe line region of the wafer if the upper test voltage limit is reached without detection of a breakdown.

4. The method of any of claims 1-3, wherein the plurality of separate IBD test structures are disposed in the scribe line region below the first and second test pads.

5. The method of claim 4, wherein the separate IBD test structures include test structures disposed in metal and via layers of the scribe line region that correspond to metal and via layers of a die in the wafer.

6. The method of claim 4, wherein the separate IBD test structures include metal to metal and metal to via IBD test structures in an M0 metal layer.

7. The method of claim 6, wherein the separate IBD test structures include metal to metal and metal to via IBD test structures in a backside power delivery layer.

8. A computer readable storage medium having instructions that when executed by a control circuitry perform the method of any of claims 1-7.

9. A wafer test apparatus including the control circuitry and computer readable storage medium as recited in claim 8.

10. A wafer test apparatus as recited in claim 9, and comprising:
a pedestal to support the wafer,
a test probe assembly with probe contacts to couple with the aggregate and first plurality test pad pairs; and
a test station to be coupled with the test probe assembly to perform a voltage breakdown test on the aggregate IBD test structure.

11. The apparatus of claim 10, wherein the test station is to perform voltage breakdown tests on the first plurality of IBD test structures if the voltage breakdown test on the aggregate IBD test structure detects a breakdown failure.

12. The apparatus of any of claims 10-11, wherein the test station is to perform voltage breakdown tests on a different aggregate IBD test structure in a different scribe line region of the wafer if the voltage breakdown test on the first aggregate IBD test does not detect a breakdown failure.

13. The apparatus of any of claims 10-12, wherein the test station includes and IBD test circuit including a controllable voltage supply to apply an incrementally increasing test voltage at the pair of aggregate test pads until either a breakdown is detected or an upper voltage limit is reached without a detected breakdown.

14. The apparatus of claim 13, wherein the IBD test circuit includes a breakdown detection circuit to determine if there is a breakdown of the first aggregate IBD test structure.

15. The apparatus of claim 14, wherein the breakdown detection circuit is part of the controllable voltage supply.
